Europäisches Patentamt

European Patent Office

Office européen des brevets

(11) Publication number: **0 254 901**
**A2**

## (12) EUROPEAN PATENT APPLICATION

(21) Application number: 87109557.6

(51) Int. Cl.⁴: **H05K 3/46**

(22) Date of filing: 02.07.87

(30) Priority: 18.07.86 US 887146

(43) Date of publication of application:
**03.02.88 Bulletin 88/05**

(84) Designated Contracting States:
**DE FR GB IT NL**

(71) Applicant: TEKTRONIX, INC.
Tektronix Industrial Park D/S Y3-121 4900
S.W. Griffith Drive P.O. Box 500
Beaverton Oregon 97077(US)

(72) Inventor: Coucher, Robert J.
Route 1 Box 355
Hillsboro Oregon 97124(US)
Inventor: Tauscher, Lauri D.
867 South 2nd Avenue
Cornelius Oregon 97113(US)

(74) Representative: Strasse, Joachim, Dipl.-Ing. et
al
Strasse und Stoffregen European Patent
Attorneys Zweibrückenstrasse 17
D-8000 München 2(DE)

(54) Lamination method and apparatus.

(57) This invention relates to a lamination press and
the manufacture of laminates in the press. The press
includes a pressure vessel divided into first and
second chambers by a flexible material. An assem-
bly of elements to be laminated is placed in the
second chamber and a vacuum is drawn in both
chambers. A higher vacuum is drawn in the first
chamber than in the second so as to prevent the
entrapment of air in the laminar assembly by external pressures. The first chamber is then flooded with
a heated, pressurized fluid, which exerts a compressive force on the laminar assembly through the
flexible material. Transfer of heat from the fluid to
the laminar assembly is monitored by circulating the
fluid through the first chamber and comparing the
entering and exiting fluid temperatures. Heat transfer
is controlled by varying the temperature of the circulating fluid and by changing its rate of flow
through the first chamber.

# LAMINATION METHOD AND APPARATUS

## TECHNICAL FIELD

The present invention relates to an improved method and apparatus for the manufacture of laminar products, and more particularly to the manufacture of laminar electronic circuit boards without the entrapment of gas between the individual layers.

Multi-layer electronic printed circuit boards are generally fabricated by laminating two or more substrates, such as fiberglass-epoxy boards, together with a thermoplastic epoxy resin. These elements are sandwiched together and pressed at an elevated temperature. These conditions are maintained until the epoxy resin cures, thereby forming a unitary rigid structure.

One problem that plagues the fabrication of multi-layer circuit boards is the entrapment of air between the individual layers. Entrapped air can cause a variety of problems. For example, the air can expand when the board is reheated, as during a wave soldering process, and cause the board to delaminate or crack; the air can change the dielectric constant of the circuit board, causing variations in the impedance of electrical conductors formed on the board; and the air can reduce the laminate breakdown voltage, resulting in catastrophic failure of the circuitry.

Another problem that is especially critical in the manufacture of epoxy-bonded laminates is that of maintaining precise control over the lamination pressure, thermal cycle and heat exchange during processing. The epoxy curing process is highly dependent on the laminate temperature and pressure profiles. If resin cross-linking occurs at other than the target temperature and pressure conditions, the strength of the interlaminar bond may be greatly reduced. Similarly, if the temperature throughout the laminar assembly is not precisely controlled, the epoxy can cure at different rates and the resulting laminate can warp under the residual thermal stress so induced.

One type of lamination apparatus used in the prior art is a mechanical ram press. A hydraulically driven heated platen is used to press and heat a laminar assembly. Such processing is highly prone to gas entrapment, as it relies exclusively on the applied pressure to drive trapped air from between the individual layers. Temperature and pressure control and distribution are also very poor.

An improvement on the mechanical ram press is the vacuum ram press, in which a vacuum is drawn between the elements of the laminar assembly before pressure is applied. This method too, however, is also prone to gas entrapment. The vacuum forms a tight seal at the edges of the assembly, but may trap gases centrally between the layers. When this happens, further application of the vacuum merely tightens the seal at the edges of the assembly and confines the trapped gas in place.

Like the mechanical ram press, the vacuum ram press provides poor temperature and pressure control and distribution.

Another approach to reducing air entrapment is illustrated by a lamination apparatus marketed by Vacuum-Press International, Inc. (Orange, California). In this device, the elements to be laminated are enveloped in a flexible material and positioned in a pressure vessel. The air within this enclosure is evacuated and the pressure vessel is then pressurized with heated carbon dioxide. The epoxy in the laminar assembly cures under the heat and pressure applied by the carbon dioxide gas.

The Vacuum-Press International device suffers from a variety of drawbacks. Foremost is its bulk and expense. The unit measures approximately twelve feet by six feet by six feet and weighs several thousand pounds. An auxiliary water cooling system is required to cool the press chamber and laminated parts after the lamination cycle is completed. The present cost of the unit is approximately $250,000. As a further drawback, the Vacuum-Press International design is oriented to the production of very large numbers of laminates at a time, which makes it inefficient for use in custom and small-lot production runs. Finally, the Vacuum-Press International device again suffers from a lack of accurate control over the critical temperature and pressure cycles.

Among the prior art patents, U.S. Patent No. 3,493,451 to Beery teaches that a permeable core layer, such as a woven fabric, can be provided between layers being laminated to facilitate the withdrawal of entrapped air. Air entrapped between the outer layers can be withdrawn through the interstices of the permeable core layer by an applied vacuum.

U.S. Patent No. 3,984,244 to Collier et al. addresses the problem of avoiding air entrapment when a thermoplastic film is applied to an irregularly surfaced printed circuit board. The invention teaches that the surface of the film adjacent the printed circuit board can be grooved with a plurality of small parallel channels. Entrapped air can then be withdrawn through such channels by a vacuum applied between the circuit board and the thermoplastic film.

U.S. Patent No. 4,388,129 to Oizumi et al. discloses techniques whereby air entrapped between layers of a laminar assembly can be caused to dissolve into the liquid bonding resin before the bonding resin is cured.

U.S. Patent No. 4,127,436 to Friel discloses a process for applying film layers to irregularly shaped surfaces. In one embodiment, the gas pressure between the film and surface is reduced below atmospheric pressure in a device which is divided into two chambers by a resilient member. The pressure in the other chamber is then increased, e.g. by venting to the atmosphere, on one side of the member, thereby forcing the film and the irregularly shaped surface firmly together.

All of these approaches suffer from the common drawback that the temperature and pressure to which the laminar assembly is subjected cannot accurately be controlled. This renders such devices and techniques poorly suited for bonding laminar elements with thermoplastic epoxy resins.

Since proper temperature and pressure profiles are so critical to production of satisfactory epoxy-bonded laminates, these parameters must be monitored accurately. In many prior art devices, including the Vacuum-Press International device, a thermocouple is used to measure the temperature of the pressure-applying medium, be it an inert gas or a heated platen. However, the temperature of concern is not the temperature of the heat transfer medium, but rather the temperature at points within the laminar assembly itself. The thermocouple measurement bears little relationship, in dynamic states, to the internal laminar assembly temperatures.

To overcome this problem, one or more thermocouples are sometimes incorporated into a test laminar assembly. The thermocouple measurements are then used to characterize the heat transfer parameters of the test assembly for a particular set of heating conditions. Production versions of the laminate can then be made based on the assumption that the characterized heat transfer parameters are accurate.

This approach is also not entirely satisfactory. The introduction of thermocouples within the test laminar assembly distorts its heat transfer characteristics, as compared with the heat transfer characteristics of the production laminar assembly. Furthermore, this method is cumbersome, requiring one or more special test runs of the lamination cycle be made to characterize the process for each board being produced.

Since the heat transfer parameters of the laminar assembly itself are so difficult to characterize, some processes are based on trial and error. In such processes, an assembly is processed under a baseline set of conditions. The finished product is then subjected to various chemical and physical testing to determine which steps in the process need to be changed. Another run is then made using the changed parameters. This cycle continues until a satisfactory end product is obtained. Thereafter, the parameters identified by trial and error are used in the fabrication of production laminates.

As is apparent from the above discussion, existing technologies are poorly suited for the production of epoxy-bonded multi-layer circuit boards.

Accordingly, a need remains for an improved method and apparatus for manufacturing such laminar assemblies.

## SUMMARY OF THE INVENTION

One object of the present invention is to provide an improved lamination method and apparatus.

Another object of the present invention is to provide a lamination method and apparatus in which air is not held entrapped by external pressures between the materials being laminated.

Still another object of the present invention is to precisely control the rate of heat transfer to an assembly being laminated.

Yet another object of the present invention is to precisely control and uniformly distribute pressure to an assembly being laminated.

Still another object of the present invention is to reduce the total time required to complete a lamination cycle.

Yet another object of the present invention is to provide real time monitoring of temperature and pressure changes within an assembly being laminated so as to enable precise control of key process variables.

This invention relates to a lamination press and the manufacture of laminates in the press. The lamination press includes a pressure vessel divided into first and second chambers by a flexible material. A laminar assembly including an epoxy bonding layer is placed in the second chamber and vacuum is drawn in both chambers. A higher vacuum is drawn in the first chamber than in the second so as to prevent the entrapment of air in the laminar assembly by external pressures. The first chamber is then flooded with a heated, pressurized fluid which exerts a compressive force on the laminar assembly through the flexible material. Transfer of heat from the fluid to the laminar assembly is monitored by circulating the fluid through the first chamber and comparing the entering and exiting fluid temperatures. Heat transfer is controlled by varying the temperature of the circulating fluid and by changing its rate of flow through the first chamber.

The foregoing and additional objects, features and advantages of the present invention will be more readily apparent from the following detailed description of a preferred embodiment thereof, which proceeds with reference to the accompanying drawings.

## BRIEF DESCRIPTION OF THE DRAWINGS

Fig. 1 is a block diagram illustrating the apparatus of the present invention.

Fig. 2 is a top plan view of a pressure vessel according to the present invention.

Fig. 3 is a schematic vertical section view taken along lines 3-3 of Fig. 2.

Fig. 4 is a schematic vertical section view taken along lines 4-4 of Fig. 2.

## DETAILED DESCRIPTION OF THE PREFERRED EMBODIMENT

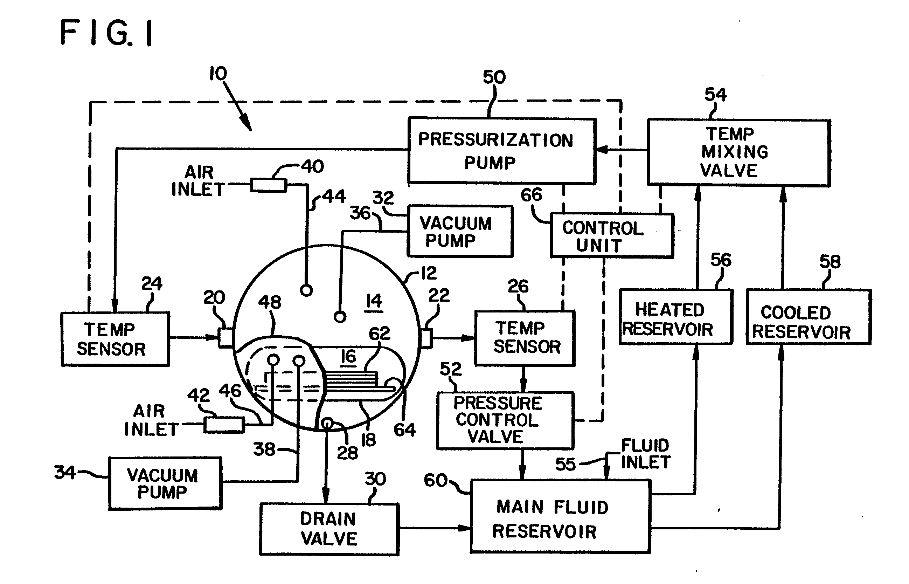

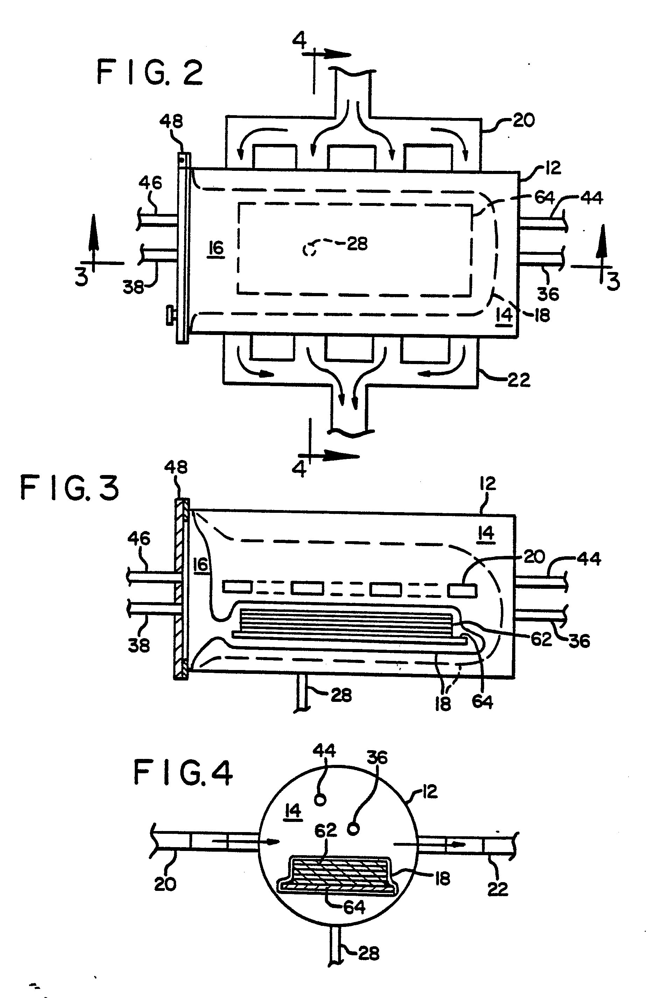

With reference to Figs. 1-4, the lamination apparatus 10 of the present invention includes a cylindrical pressure vessel 12 separated into first and second chambers 14, 16 by a flexible, nonporous material 18. Pressure vessel 12 has attached to it two manifolds 20, 22 (Figs. 2-4) for allowing pressurized fluids to enter and exit first chamber 14, respectively. Located at the input and output junctions of these manifolds are temperature sensors 24, 26 for determining temperatures of the entering and exiting fluids. A drain 28 and associated drain valve 30 are provided at the lowest point of chamber 16 to enable complete removal of fluid when desired. Two vacuum pumps 32, 34 are connected to chambers 14, 16 by conduits 36, 38, respectively, to enable independent depressurization of each chamber. Similarly, two air inlet valves 40, 42 are connected to chambers 14, 16 by conduits 44, 46 to allow the introduction of air into each chamber. A door 48 opens into second chamber 16 to allow the introduction of the materials to be laminated.

In the preferred embodiment, flexible material 18 is formed in the shape of a bladder and is sealed about its opening to the inside wall of vessel 12 near door 48.

Input fluid manifold 20 is fed with fluid supplied by a pressurization pump 50 (Fig. 1) with variable pressurization capability. On the output side of output fluid manifold 22 and temperature sensor 26 is a variable pressure control valve 52. The variable pressurization capability of pump 50 and the variable pressure control valve 52 enable the fluid pressure, as well as the rate of fluid flow, in chamber 14 to be independently increased or decreased, as desired, throughout the lamination cycle.

Fluid for pressurization pump 50 is supplied from a fluid temperature mixing valve 54, which can be adjusted to enable variation of the temperature of the supplied fluid. Fluid for mixing valve 54 is in turn supplied by two reservoirs 56, 58. Reservoir 56 is heated, as by an electrical heater, to a predetermined temperature. Reservoir 58 is maintained at room temperature, or more preferably cooled by a refrigeration unit (not shown). Reservoirs 56, 58 in turn receive fluid from a single main reservoir 60 which is fed by the fluid returning from first chamber 14 through pressure control valve 52. A filling port 55 leading into reservoir 60 is used to provide an initial charge of fluid.

The invention operates as follows: materials 62 to be laminated are placed on a platform 64 in second chamber 16 through door 48. The door is closed and sealed. Vacuum pumps 32, 34 draw a vacuum in chambers 14, 16 such that the pressure in second chamber 16, containing the material to be laminated, is equal to or slightly higher than the pressure in first chamber 14. This allows complete removal of any air entrapped between layers of materials to be laminated and eliminates the opportunity for external pressure to entrap such air. Once sufficient vacuum has been drawn for a desired amount of time, fluid is allowed to enter and fill first chamber 14. As fluid enters chamber 14 and the chamber is pressurized, the flexible material 18 separating the two chambers is compressed onto, and forced to conform to, the surfaces of the material being laminated. Material 18 in Fig. 3 is shown in dashed lines in an uncompressed state and in a solid line in a compressed state.

The rate of change of temperature of the materials being laminated can be controlled and varied as desired by monitoring and controlling the input and output fluid flow rate and temperature. By using a fluid as the heat transfer medium, the efficiency of the transfer is enhanced and the ability to control the rate of transfer is superior to that offered by existing technologies. The pressure exerted on the materials being laminated can also be controlled and varied by monitoring and controlling the pressure generated by the pressurization pump 50 and the rate of flow through the pressure control valve 52.

Once the heating and pressurization cycle has been completed, the temperature and pressure in the vessel 12 can be returned to ambient at a desired rate. This is again accomplished by controlling the temperature and pressure of the input fluid. When the now laminated materials reach ambient temperature and pressure, drain valve 30 can be opened, allowing complete removal of fluid from chamber 14. At this time, door 48 of chamber 16 can be opened and the laminated material removed. The cycle can then be repeated on the next materials to be laminated.

In the preferred embodiment, pressurization pump 50, pressure control valve 52 and temperature mixing valve 54 are provided with electronic controls to enable the dynamic variation of fluid temperature, pressure and flow rate during the lamination cycle. These electronic controls are operated by a microprocessor control unit 66 in accordance with a programmed sequence of instructions. Microprocessor control unit 66 is provided with real time feedback on the heat transfer to the laminar assembly by temperature sensors 24, 26, thereby enabling closed-loop regulation of thermal process parameters.

In other embodiments of the present invention, pressurization pump 50, pressure control valve 52 and temperature mixing valve 54 are operated manually.

The temperature and pressure parameters selected for a lamination cycle will vary, depending on the precise application. These parameters are generally selected to be those at which cross-linking of the epoxy resin occurs most rapidly.

In an illustrative operation, the fluid circulated through chamber 14 begins at room temperature and is heated at a given rate, such as 14° Fahrenheit per minute, until the desired resin curing temperature is reached. The fluid is then maintained at this temperature until the elements of the laminar assembly reach thermal equilibrium. This condition is determined by monitoring the temperature of the fluid entering and exiting chamber 14 by temperature sensors 24, 26. Until the laminar assembly reaches thermal equilibrium, it will withdraw heat from the fluid, causing the temperature of the exiting fluid to be less than the temperature of the entering fluid. When the laminar assembly reaches thermal equilibrium, no further heat transfer takes place and the temperature of the exiting fluid will be equal to the temperature of the entering fluid.

After the laminar assembly has reached thermal equilibrium, the pressure of the fluid in first chamber 14 is typically increased to the optimum resin bonding pressure. This pressure is controlled by pressure control valve 52 in cooperation with pressurization pump 50. This temperature and pressure combination is then maintained for a period sufficient for the epoxy resin to completely cross-link and cure.

After the resin has cured, the laminar assembly is cooled by circulating fluid from cooled reservoir 58 through first chamber 14. Again, the thermal state of the laminar assembly can be monitored by comparing the exiting fluid temperature with the entering fluid temperature. When the laminate has achieved the desired temperature, the fluid circulation is stopped and first chamber 14 drained through drain 28 and valve 30. Air is then introduced into the first and second chambers by air inlet valves 40, 42. The finished laminate can then be removed and another laminar assembly placed in second chamber 16 to repeat the process.

In other lamination processes, it may be desirable to apply pressure to the laminar assembly before it reaches the desired curing temperature. In still other applications, the particular pressure and temperature conditions under which the laminate cools may be critical. The lamination press of the present invention can be operated to provide any desired thermal and pressure forces to the laminar assembly during processing.

In the preferred embodiment, the heating and pressurizing fluid used in apparatus 10 is a substantially non-compressible liquid. Suitable liquids may be metallic (e.g., mercury), organic (e.g., oil, hydraulic fluids, etc.), inert (e.g., Fluorinert) or inorganic.

The present invention provides a number of advantages over prior art techniques. First, the apparatus functions in such a manner that air is not entrapped, or held entrapped by external pressures, between the materials to be laminated. Secondly, better control over the thermal cycle and rate of heat transfer to the laminated materials is made possible by monitoring and controlling the input and output fluid temperatures and flow rate. By using a fluid as the heat transfer medium, the efficiency of the transfer is enhanced and the ability to control the rate of transfer is improved. Thirdly, the use of a non-compressible fluid allows lamination pressure to be controlled more uniformly and distributed more consistently than with existing technologies, such as gas pressurized systems. Fourthly, laminated materials can be cooled more quickly after lamination is complete, thus reducing total lamination time requred. Fifthly, real time monitoring of temperature and pressure changes within the apparatus is made possible, enabling superior control of the key process variables. Sixthly, the use of a fluid as the pressurizing medium enables the use of a smaller pressure vessel than is possible with existing technologies, thus enhancing compatability of pressing operations with other "in-line" manufacturing operations (as opposed to "batch" operations).

It will be appreciated that the laminate fabrication process of the present invention has application well beyond the production of printed circuit boards. Among the wide variety of suitable applications, examples include the manufacture of aeronautical structural members, construction materials and skis. The present invention can be operated at temperatures and pressures ranging up through 1000° F and 1000 p.s.i. respectively, thereby permitting the fabrication of these and a broad range of other products.

While the above discussion has been made with reference to a single preferred embodiment, it will be apparent to those skilled in the art that the invention can be modified in arrangement and detail without departing from its basic principles. I claim all such modifications coming within the scope and spirit of the following claims.

**Claims**

1. A method for laminating the elements of a laminar assembly together comprising the steps:
 providing first and second chambers separated by a flexible member;
 placing the elements of the laminar assembly in the second chamber;
 lowering the pressures in the first and second chambers;
 filling the first chamber with a liquid; and
 pressurizing the liquid in the first chamber so that the flexible material separating the two chambers is compressed onto the elements of the laminar assembly in the second chamber.

2. The method of claim 1 which further includes the step of lowering the pressures in the first and second chambers such that the pressure in the second chamber is greater than or equal to the pressure in the first chamber.

3. The method of claim 1 which further comprises the steps:
 heating the liquid; and
 circulating the heated liquid through the first chamber.

4. The method of claim 3 which further comprises the steps:
 circulating the heated liquid through the first chamber by introducing it into a liquid inlet and withdrawing it from a liquid outlet; and
 monitoring the temperatures of the liquid introduced and the liquid withdrawn to determine the thermal state of the laminar assembly.

5. A method for laminating the elements of a laminar assembly together comprising the steps:
 providing first and second chambers separated by a flexible member;
 placing the elements of the laminar assembly in the second chamber;
 filling the first chamber with a heated liquid;
 controlling the temperature of the heated liquid;
 pressurizing the heated liquid in the first chamber so that the flexible material separating the two chambers is compressed onto the elements of the laminar assembly in the second chamber;
 regulating the pressure of the heated liquid;
 circulating the heated liquid through the first chamber by introducing it into a liquid inlet and withdrawing it from a liquid outlet;
 controlling the rate of liquid circulation through the first chamber; and
 monitoring the temperatures of the heated liquid entering and exiting the first chamber to determine the thermal state of the laminar assembly.

6. A method for laminating the elements of a laminar assembly together comprising the steps:
 heating a fluid;
 circulating the heated fluid through a heat transfer apparatus;
 transmitting heat from the heat transfer apparatus to the elements of the laminar assembly;
 monitoring the temperatures of the fluid entering and exiting the heat transfer apparatus to determine the thermal state of the elements of the laminar assembly; and
 applying pressure to the elements of the laminar assembly.

7. The method of claim 6 which further comprises the steps:
 pressurizing the heated fluid; and
 using the pressurized fluid to apply pressure to the elements of the laminar assembly.

8. In a method for laminating a laminar assembly together, the improvement comprising:
 transferring heat to the laminar assembly through a liquid medium; and
 applying pressure to the laminar assembly through said liquid medium.

9. An apparatus for laminating the elements of a laminar assembly together, comprising: a vessel;
 flexible means for dividing the vessel into first and second chambers;
 door means for providing access to the second chamber so that the elements of the laminar assembly can be introduced therein;
 evacuation means for reducing the pressures in the first and second chambers;
 means for filling the first chamber with a fluid; and
 pressurizing means for pressurizing the fluid in the first chamber so that the flexible material separating the two chambers is compressed onto the elements of the laminar assembly.

10. The apparatus of claim 9 which further comprises:
 heating means for heating the fluid;
 circulation means for circulating the heated fluid through the first chamber; and
 temperature sensing means for monitoring the temperatures of the fluid entering and exiting the first chamber.

FIG. I

0 254 901

0 254 901

FIG. 2

48

46

38

3

16

28

12

64  44

14  18

36

3

20

22

FIG. 3

48

46

38

16

12

14

20  44

62  36

28

18  64

FIG. 4

44  36

14

12

62

20

18

22

64

28